# EUROPEAN PATENT SPECIFICATION

(11) **EP 1 180 282 B1**
(45) Date of publication and mention of the grant of the patent: **17.05.2006**
(21) Application number: 00987831.5
(22) Date of filing: 30.12.2000
(51) Int. Cl.: H04L 12/28, H04N 7/24

(54) **METHOD AND APPARATUS FOR TRANSMITTING AND RECEIVING MULTIMEDIA DATA**
VERFAHREN UND VORRICHTUNG ZUM SENDEN UND EMPFANGEN VON MULTIMEDIA-DATEN
PROCEDE ET APPAREIL PERMETTANT DE TRANSMETTRE ET DE RECEVOIR DES DONNEES MULTIMEDIA

(30) Priority: 29.03.2000 US 192936 P; 06.05.2000 KR 2000024207; 20.09.2000 KR 2000055201
(43) Date of publication of application: 20.02.2002
(73) Proprietor: SAMSUNG ELECTRONICS CO., LTD., Suwon City, Kyungki-do 442-373 (KR); The Regents of the University of California, Oakland, California 94607-5200 (US)
(72) Inventor: PARK, Dong-Seek, Samsung Electronics Co. Ltd., Suwon-city, Kyungki-do 442-373 (KR); PARK, Jeong-Hoon, Samsung Electronics Co. Ltd., Suwon-city, Kyungki-do 442-373 (KR); LEE, Yung-Lyul, Songpa-gu, Seoul 138-160 (KR); VILLASENOR, John, Los Angeles, CA 90095 (US); LI, Adam, H., Los Angeles, CA 90095 (US)
(74) Representative: Geary, Stuart Lloyd
(86) International application number: PCT/KR2000/001571
(87) International publication number: WO 2001/074012

(56) References cited:
- JP-A- 11 088 462
- BOYCE J M: "Packet loss resilient transmission of MPEG video over the Internet - Principles, Protocols, and Architecture" , SIGNAL PROCESSING. IMAGE COMMUNICATION, ELSEVIER SCIENCE PUBLISHERS, AMSTERDAM, NL, VOL. 15, NR. 1-2, PAGE(S) 7-24 XP004180635 ISSN: 0923-5965 * abstract * * paragraph [0001] * * paragraph [2.2.1] * * paragraph [0003] * * figure 4 *
- GUILLEMOT C ET AL: "INTEGRATING MPEG-4 INTO THE INTERNET" , PROCEEDINGS OF THE EUROPEAN CONFERENCE ON MULTIMEDIA APPLICATIONS,SERVICES AND TECHNIQUES, XX, XX, PAGE(S) 181-196 XP000934231 * paragraph [03.2] * * paragraph [03.3] * * paragraph [03.4] * * figure 2 *
- GHARAVI H ET AL: "PARTITIONING OF MPEG CODED VIDEO BITSTREAMS FRO WIRELESS TRANSMISSION" IEEE SIGNAL PROCESSING LETTERS, IEEE SIGNAL PROCESSING SOCIETY, US, vol. 4, no. 6, 1 June 1997 (1997-06-01), pages 153-155, XP000655961 ISSN: 1070-9908
- ITU : "Media-independent Error Correction using RTP" ITU TELECOMMUNICATION STANDARDIZATION SECTOR - STUDY GROUP 16, [Online] - 4 June 1997 (1997-06-04) pages 1-17, XP002241047 Retrieved from the Internet: <URL:http://mmlab.snu.ac.kr/~mcast/multica st/paper/fec.rtf> [retrieved on 2003-05-14]
- GUERRI J.C. ET AL.: 'A feedback packet-level error control for real time applications in wireless networks' VEHICULAR TECHNOLOGY CONFERENCEM 1999. VTC'99-FALL, IEEE VTC 50TH vol. 2, 19 September 1999 - 22 September 1999, pages 879 - 883
- MEGGERS J., SUBRAMANIAM R.: 'A new feedback error control scheme for block based video communication in packet switched wireless networks' COMPUTERS AND COM, 1999 PROCEEDINGS IEEE INTERNATIONAL SYMPOSIUMS ON 06 July 1999 - 08 July 1999, pages 324 - 330
- GUERRI J.C. ET AL.: 'Dynamic frequency and resource allocation with adaptive error control based on RTP for multi-media QoS guarantees in wireless networks' MULTIMEDIA COMPUTING AND SYSTEMS, 1999. IEEE INTERNATIONAL CONFERENCE ON vol. 2, 07 June 1999 - 11 June 1999, pages 333 - 337
- ROSENBERG J.; SCHULZRINNE H.: 'An RTP Payload Format for Generic Forward Error Correction, RFC 2733' 31 December 1999, XP002185476

## Description

The present invention relates to a method of transmitting packetized multimedia data in a wireless packet network comprising forming a plurality of data packets, forming an error-protection packet for error-protecting said plurality of packets and transmitting said data and error-protection packets, an error-correction packet signal for protecting a plurality of multimedia data packets comprising a Real-Time Protocol Header, a forward error correction header and a forward error correction payload, an apparatus for transmitting packetized multimedia data in a wireless packet network comprising packetizing means for forming a plurality of data packets, error-protection means for forming an error-protection packet for error-protecting a plurality of packets produced by the packetizing means and means for transmitting data and error-protection packets produced by the packetizing and error-protection means, a method of regenerating at least a portion of a lost packet and an apparatus for regenerating at least a portion of a lost packet.

In general, the H. 323 protocol is the preferred protocol of the International Telecommunications Union, Telecommunications Sector (ITU- T) for video conferencing in a communications environment in which a quality of service (QoS) is not guaranteed, such as the Internet-based transmission control protocol/Internet protocol (TCP/IP) and the user datagram protocol (UDP).

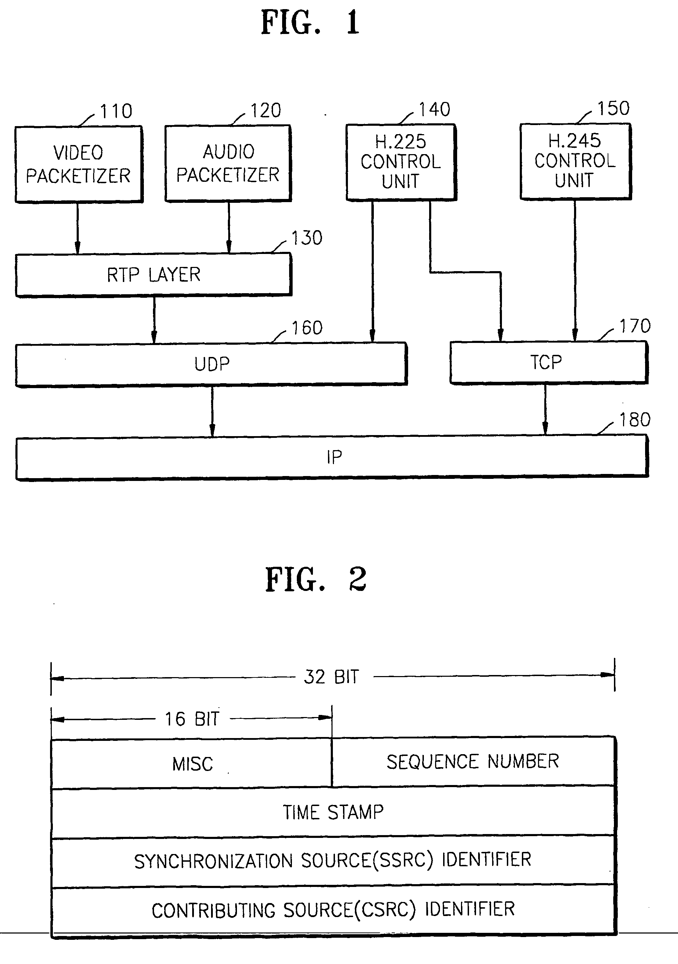

Referring to FIG. 1, a video packetizer 110 and an audio packetizer 120 perform source-encoding and create packets of video data and audio data. A real-time transmission protocol (RTP) layer 130 inserts a time stamp in the packets of the video data and the audio data and creates a RTP packet by combining the video data packet with the audio data packet, which are created in the video packetizer 110 and the audio packetizer 120, respectively. The RTP layer 130 provides functions such as identification of data type, checking of sequence numbers, transmission of internal time stamps, and monitoring of data transmission. Here, the header of the RTP layer 130, as shown in FIG. 2, includes a miscellaneous (MISC) field, a sequence number field, a time stamp field, a synchronization source (SSRC) identifier, and a contributing source (CSRC) identifier. Here, the MISC field is a 16-bit field including version, padding, extension, CSRC count, marker, and payload type information. A user datagram protocol (UDP) layer 160 mixes the RTP packet created in the RTP layer 130 with a H. 225 control signal generated from a H. 225 control unit 140. A transmission control protocol (TCP) layer 170 creates a TCP packet to be re-transmitted, by using the H. 225 control signal generated from the H. 225 control unit 140 and a H. 245 media control signal generated from a H. 245 control unit 150. An Internet protocol (IP) layer 180 creates an IP packet by using a UDP packet created in the UDP layer 160 and a TCP packet created in the TCP layer 170.

However, in the H. 323 shown in FIG. 1, there are no error-resilient layers between a source packetizer formed of the video packetizer 110 and the audio packetizer 120, and the RTP layer 130, and the header has the structure shown in FIG. 2 in the RTP layer 130.

As a result, when there is no error-protection capability, which is robust to the source packetizer (or source codec layer), packet loss can occur in an error-prone environment such as a wireless environment.

A conventional forward error correction (FEC) scheme such as convolution coding and bose-chaudhuri-hocquenghem (BCH) is implemented only in the physical layer, and due to the complexity, it is difficult for the FEC scheme to be implemented in the layers before the RTP layer.

RFC 2733 describes an RTP payload format for generic forward error correction which is developed further by the present invention.

The reader may find additional background information in Boyce, J.M., "Packet loss resilient transmission of MPEG video over the Internet", Signal Processing: Image Communication, 1999, vol. 15, pp. 7-24.

A method of transmitting packetized multimedia data in a wireless packet network, according to the present invention, is characterised in that the error-protection packet provides unequal protection to the packets in said plurality of data packets by forming a first forward error-correction code using corresponding parts of said data packets and forming a second forward error-correction code using corresponding parts of packets belonging to a subset of said data packets, wherein the data packet parts, used for the second forward error-correction code, are continuations from data packet parts used for the first error-correction code.

An error-correction packet signal for protecting a plurality of multimedia data packets, according to the present invention, is characterised in that the forward error correction payload comprises:
a forward error-correction code header comprising the sequence number of the first packet protected by forward error-protection code packet and a mask;
a first unequal protection layer header defining a first data length protected by a first forward error correction code;
said first forward error correction code;
a second unequal protection layer header defining a second data length, extending said first data length, protected by a second forward error correction code and a mask; and
said second forward error correction code, and
the packets protected by the first and second forward error-correction codes can be determined from said sequence number and the masks in the forward error-correction header and the second unequal protection layer header respectively.

An apparatus for transmitting packetized multimedia data in a wireless packet network, according to the present invention, is characterised in that the error-protection means is configured to produce an error-protection packet providing unequal protection to packets produced by the packetizing means and comprises means for forming a first forward error-correction code using corresponding parts of said data packets and forming a second forward error-correction code using corresponding parts of packets belonging to a subset of said data packets, wherein the data packet parts, used for the second forward error-correction code, are continuations from data packet parts used for the first error-correction code.

A method of regenerating at least a portion of a lost packet, according to the present invention, comprises:
receiving a plurality of data packets;
detecting the non-reception of a data packet;
receiving an error-correction packet signal according to the present invention;
regenerating a first part of the unreceived data packet using said first error-correction code and data from said received data packets;
determining whether said second forward error-correction code relates to said unreceived packet from said second unequal protection layer header; and
if said second forward error-correction code relates to said unreceived data packet, regenerating a second part of the unreceived data packet using said second forward error-correction code and data from said received data packets.

An apparatus for regenerating at least a portion of a lost packet, according to the present invention, comprises:
means for receiving a data packets and an error-correction packet signal according to the present invention;
first regenerating means for regenerating a first part of an unreceived data packet using said first error-correction code of a received error-correction packet signal and data from received data packets; and
second regenerating means for:
   determining whether said second forward error-correction code of a received error-correction packet signal relates to an unreceived packet, partially regenerated by the first regenerating means, from the second unequal protection layer header of said received error-correction packet signal; and
if said second forward error-correction code does relate to said unreceived data packet, regenerate a second part of the unreceived data packet using said second forward error-correction code and data from said received data packets.

Embodiments of the present invention will now be described, by way of example, with reference to FIGS. 3 to 8 of the accompanying drawings, in which:
FIG. 1 is a detailed block diagram of the H. 323 ;
FIG. 2 is a block diagram of the header of real-time transport protocol (RTP) of FIG. 1;
FIG. 3 illustrates the structure of protocol for transmitting multimedia data according to the present invention ;
FIG. 4 is a flowchart illustrating a method for transmitting multimedia data according to the present invention;
FIG. 5 illustrates an embodiment of an unequal error protection method according to the present invention ;
FIGS. 6A through 6D are format diagrams of a forward error correction (FEC) packet of FIGS. 5A through 5C;
FIG. 7 is a flowchart illustrating a method for receiving multimedia data according to the present invention; and
FIG. 8 illustrates a communications system in which the method for receiving multimedia data according to the present invention is implemented.

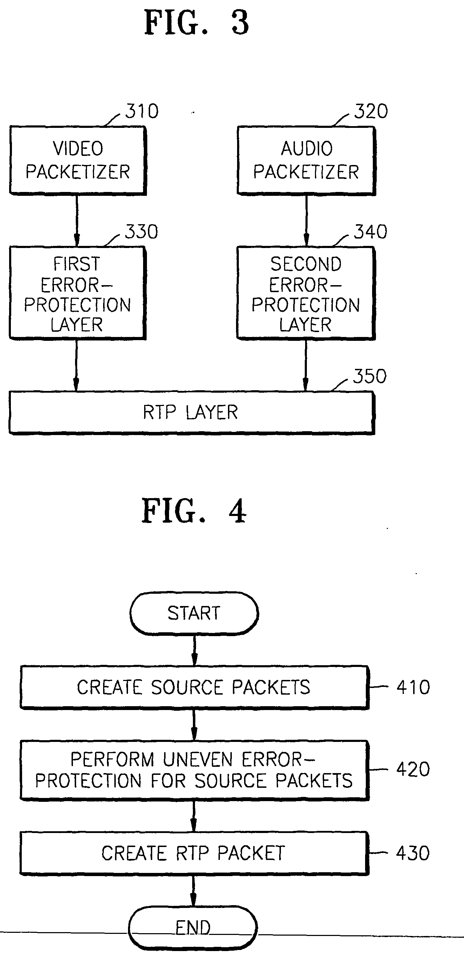

Referring to FIG. 3, the protocol for transmitting new multimedia data inserts a first error-protection layer 330 and a second error-protection layer 340, respectively, between a source packetizer including a conventional video packetizer 310 and an audio packetizer 320, and a real-time transmission protocol(RTP) layer 350.

The first error-protection layer 330 and the second error-protection layer 340 create a forward error correction (FEC) packet, the result of performing unequal error-protection with respect to one video or audio packetizer or a plurality of video or audio packetizer, which is or are packetized in the video packetizer 310 and the audio packetizer 320.

Referring to FIG. 4, first, the video packetizer 310 and the audio packetizer 320 creates video data packets and audio data packets, respectively (step 410).

Next, the first and second error-protection layers 330 and 340 perform unequal error-protection with respect to the created video data packets and audio data packets (step 420). That is, an unequal error protected FEC packet is added to a number (N) of video data packets and audio data packets.

Next, the RTP layer 350 inserts a time stamp in each packet and creates one RTP packet by combining the video data packets and the audio data packets (step 430).

In another preferred embodiment, protocol for transmitting new multimedia data can add the FEC packet, which is unequally error-protected with respect to the source packets, to the upper layer of the RTP layer, and in the RTP layer, the RTP packet can be formed of payload to which the FEC packet, which is unequally error-protected with respect to an arbitrary RTP header and the source packets, is added.

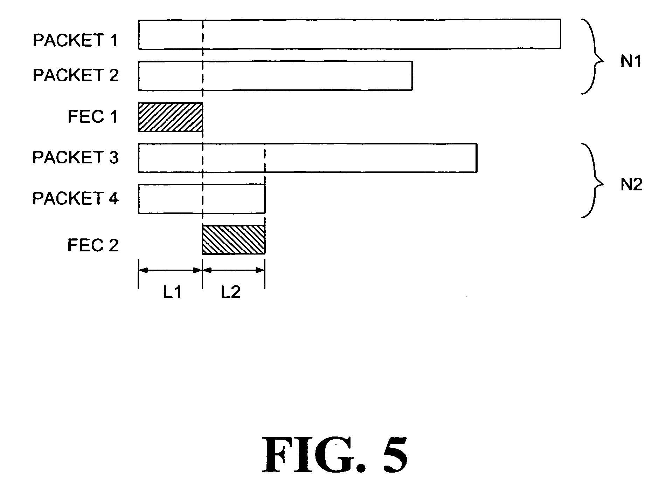

Referring to FIG. 5, when a number (N = N1 + N2) of video and audio data packets (packet1 packet 2, packet 3, and packet 4) are created as RTP packets, an FEC 1 and an FEC 2, which correspond to the redundancy of lengths L1 and L2 of N1 + N2 and N2 packets respectively, are added to an RTP packet. Here, N1, N2, L1, and L2 are system-dependent. Also, the protected portions may be groups of header information and motion vectors when data partitioning is used in MPEG-4 video and H. 263. The redundancy may be bit-by-bit exclusive OR (XOR) and a Reed-Solomon code corresponding to error-checking or error-protection.

In still another preferred embodiment, when a number (N) of video and audio data packets (packet 1, packet 2, packet 3, and packet 4) are combined with one another and created as a RTP packet, redundancy information can be differently added for RTP packets with respect to syntaxes having different importance of one source packet or a plurality of source packets.

When the created RTP packet is decoded, a recipient can correct a bit error occurring in a channel on the basis of the redundancy information, which is unequally added for a multimedia RTP packet, which is received a through predetermined protocol.

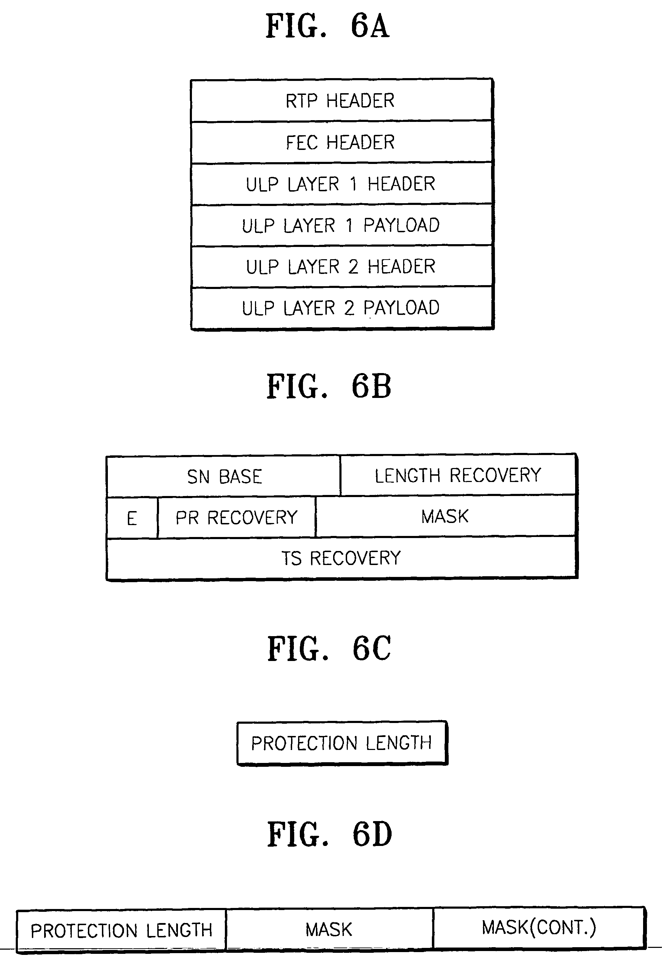

Referring to FIG. 6A, an FEC packet includes an RTP header, an FEC header, a first unequal level protection (ULP) layer header ULP layer 1 header, a first ULP layer payload ULP layer 1 payload, a second ULP layer header ULP layer 2 header, and a second ULP layer payload ULP layer 2 payload. FIG. 6B is a format diagram of the FEC header of FIG. 6A. A payload type (PT) for identifying a FEC packet and a sequence number SN corresponding to the number of the RTP packet are stored in the RTP header. The first and second ULP layers include protection level information and payloads of lengths L1 and L2.

The FEC header of FIG. 6B has a total of 12 bytes and includes a sequence number base field (SN base) corresponding to the sequence number of a first RTP packet protected by the FEC packet, a length recovery field (Length recovery), an extension field (E), a payload type recovery field (PT recovery), a mask field for indicating the packets protected by the FEC packet (mask), and a time stamp recovery field (TS recovery).

Referring to FIG. 6C, the first ULP layer header ULP layer 1 header includes a 16-bit protection length field.

Referring to FIG. 6D, the second ULP layer header ULP layer 2 header includes a total of 16-bit protection length field and a 24-bit mask field.

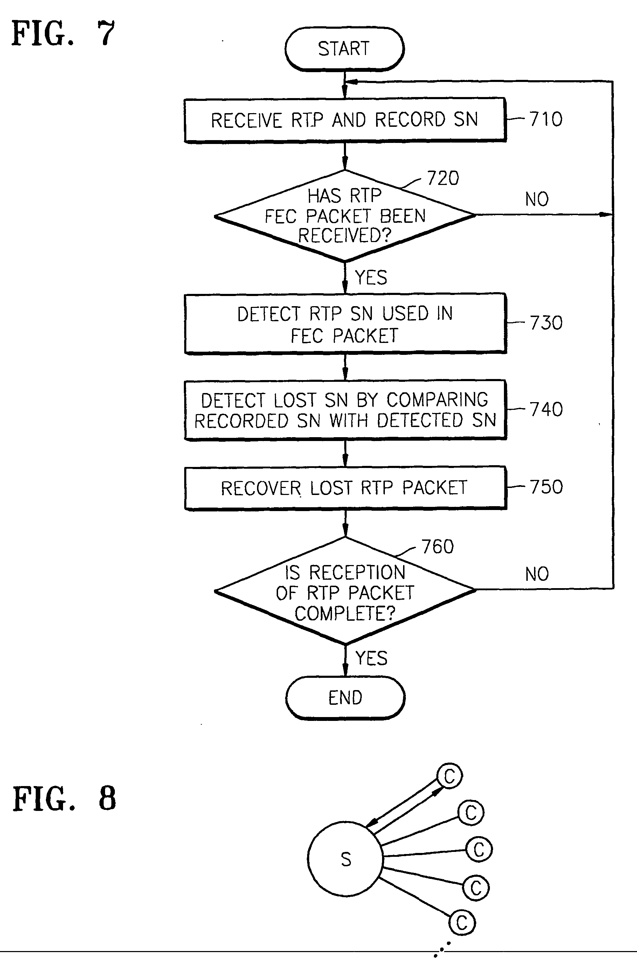

Referring to FIG. 7, a receiver receives RTP packets and transmits the RTP packets to an upper layer and stores the contents of the RTP packets in a buffer. The receiver stores the received RTP packets in the buffer until receiving a FEC packet.

First, an RTP packet is received and the sequence number of the received RTP packet is checked (step 710). Here, the sequence number of received RTP packets is recorded in a separate memory location.

Next, it is determined whether the RTP packet is the FEC packet by referring to the payload type (PT) in the header of the received RTP packet (step 720).

Next, if the RTP packet is the FEC packet in the step 720, the sequence numbers of the RTP packets protected by the FEC packet is detected by referring to the SN base field and the mask field of the FEC header (step 730). In the case where the FEC packet is formed of two or more ULP layers, the RTP sequence number used in the corresponding ULP layers is detected by referring to the mask field contained in the header of each of the second, third etc. ULP layers (step 730).

Next, the sequence number corresponding to a lost RTP packet is detected by comparing the RTP sequence numbers recorded in the separate memory with the sequence numbers of the RTP packets protected by the FEC packet (step 740). For example, if the RTP sequence numbers recorded in the memory are 1,2,4 and the sequence numbers of the RTP packets protected by the FEC packet are 1,2,3, and 4, the lost RTP packet had sequence number 3.

Next, the lost RTP packet, i.e. the RTP packet with sequence number 3, that has not been received is recovered (step 750). That is, the RTP packet that has not been received is recovered using the first ULP layer payload and the received RTP packets. In the case where there are two or more ULP headers in the FEC packet, the RTP packet that has not been received is recovered using each of the relevant ULP layer payloads. The lost RTP packet is restored by decoding the XOR or RS coded information in the FEC packet in conjunction with the received RTP packets also protected by the FEC packet.

The steps are repeated until the reception of RTP packets is completed (step 760).

Referring to FIG. 8, in order to provide the RTP packet, point-to-point connection having one channel between a client C and a server S or multicasting connection having a plurality of channels between the client C and the server S are provided. That is, the server S employing the point-to point connection transmits the RTP packets and the FEC packets to the client C. Here, when the client C does not have the function of receiving the FEC packet, the FEC packets are discarded. The server S employing the multicasting connection transmits the RTP packet and FEC packet, respectively; via separate channels to the client C.

The above encoding and decoding methods can be embodied in a computer program. Codes and code segments encompassing the program can be easily inferred to by a skilled computer programmer in the art. Also, the program can be realized in media used in a computer and in a common digital computer for operating the program. The program can be stored in computer readable media. The media can include magnetic media such as a floppy disk or a hard disk and optical media such as a CD-ROM or a digital video disc (DVD). Also, the program can be transmitted by carrier waves such as the Internet.

### Industrial Applicability

As described above, error resilience of multimedia data (especially that of video data) can be increased by unequally error-protecting with respect to the source packets without changing the stack of transmission/reception protocol in a conventional packet network such as H.323.

## Claims

1. A method of transmitting packetized multimedia data in a wireless packet network, the method comprising:
forming a plurality of data packets;
forming an error-protection packet for error-protecting said plurality of packets; and
transmitting said data and error-protection packets,
**characterised in that** the error-protection packet provides unequal protection to the packets in said plurality of data packets by forming a first forward error-correction code using corresponding parts of said data packets and forming a second forward error-correction code using corresponding parts of packets belonging to a subset of said data packets, wherein the data packet parts, used for the second forward error-correction code, are continuations from data packet parts used for the first error-correction code.

2. A method according to claim 1, wherein said data packets are formed as Real-Time Transmission Protocol packets.

3. A method according to claim 1 or 2, wherein the forward error correction codes are XOR or Reed-Solomon codes.

4. A method according to claim 1, 2 or 3, including adding a forward error-correction header comprising the sequence number of the first packet protected by the forward error protection codes and a mask, adding a first unequal protection layer header to the first forward error-correction code and adding a second unequal protection layer header to the second forward error-correction code, wherein:
the first unequal protection layer header comprises the length of the data protected by the first error-correction code,
the second unequal protection layer header comprises the length of the data protected by the second forward error-correction code and a mask, and
the packets protected by the first and second forward error-correction codes can be determined from said sequence number and the masks in the forward error-correction header and the second unequal protection layer header respectively.

5. A method according to any preceding claim, wherein the level of protection afforded a data packet is set in dependence on the syntactical significance of the packet.

6. An error-correction packet signal for protecting a plurality of multimedia data packets, the signal comprising a Real-Time Protocol Header, a forward error correction header and a forward error correction payload, **characterised in that** the forward error correction payload comprises:
a forward error-correction code header comprising the sequence number of the first packet protected by forward error-protection code packet and a mask;
a first unequal protection layer header defining a first data length protected by a first forward error correction code;
said first forward error correction code;
a second unequal protection layer header defining a second data length, extending said first data length, protected by a second forward error correction code and a mask; and
said second forward error correction code,
such that
the packets protected by the first and second forward error-correction codes can be determined from said sequence number and the masks in the forward error-correction header and the second unequal protection layer header respectively.

7. An apparatus for transmitting packetized multimedia data in a wireless packet network, the apparatus comprising:
packetizing means for forming a plurality of data packets;
error-protection means for forming an error-protection packet for error-protecting a plurality of packets produced by the packetizing means; and
means for transmitting data and error-protection packets produced by the packetizing and error-protection means,
**characterised in that** the error-protection means is configured to produce an error-protection packet providing unequal protection to packets produced by the packetizing means and comprises means for forming a first forward error-correction code using corresponding parts of said data packets and forming a second forward error-correction code using corresponding parts of packets belonging to a subset of said data packets, wherein the data packet parts, used for the second forward error-correction code, are continuations from data packet parts used for the first error-correction code.

8. An apparatus according to claim 7, wherein the packetizing means is configured to form said data packets as Real-Time Transmission Protocol packets.

9. An apparatus according to claim 7 or 8, wherein error-protection means is configured to generate the error correction codes as XOR or Reed-Solomon codes.

10. An apparatus according to claim 9, including means for adding a forward error-correction header comprising the sequence number of the first packet protected by the forward error protection codes and a mask, means for adding a first unequal protection layer header to the first forward error-correction code and means for adding a second unequal protection layer header to the second forward error-correction code, wherein:
the first unequal protection layer header comprises the length of the data protected by the first error-correction code,
the second unequal protection layer header comprises the length of the data protected by the second forward error-correction code and a mask, and
the packets protected by the first and second forward error-correction codes can be determined from said sequence number and the masks in the forward error-correction header and the second unequal protection layer header respectively.

11. An apparatus according to any one of claims 7 to 10, wherein the error-protection means is configured such that the level of protection afforded a data packet is settable in dependence on the syntactical significance of the packet.

12. A method of regenerating at least a portion of a lost packet, the method comprising:
receiving a plurality of data packets;
detecting the non-reception of a data packet;
**characterised by**
receiving an error-correction packet signal according to claim 6;
regenerating a first part of the unreceived data packet using said first error-correction code and data from said received data packets;
determining whether said second forward error-correction code relates to said unreceived packet from said second unequal protection layer header; and
if said second forward error-correction code relates to said unreceived data packet, regenerating a second part of the unreceived data packet using said second forward error-correction code and data from said received data packets.

13. An apparatus for regenerating at least a portion of a lost packet, the apparatus comprising:
means for receiving data packets and an error-correction packet signal according to claim 6;
means for detecting the non-reception of a data packet;
first regenerating means for regenerating a first part of an unreceived data packet using said first error-correction code of a received error-correction packet signal and data from received data packets; and
second regenerating means for:
determining whether said second forward error-correction code of a received error-correction packet signal relates to an unreceived packet, partially regenerated by the first regenerating means, from the second unequal protection layer header of said received error-correction packet signal; and
if said second forward error-correction code does relate to said unreceived data packet, regenerate a second part of the unreceived data packet using said second forward error-correction code and data from said received data packets.

## Patentansprüche

1. Verfahren zum Übertragen von paketisierten Multimediadaten in einem Funknetz, das Verfahren umfasst:
Bilden einer Vielzahl von Datenpaketen,
Bilden eines Fehlerschutzpaketes zum Schützen der Vielzahl von Paketen vor Fehlern und
übertragen der Daten und des Fehlerschutzpaketes,
**dadurch gekennzeichnet, dass**
das Fehlerschutzpaket durch Bilden eines ersten Vorwärtsfehlerkorrekturcodes, der entsprechende Teile der Datenpakete verwendet, und Bilden eines zweiten Vorwärtsfehlerkorrekturcodes, der entsprechend Teile von Paketen, die zu Teilmengen von Datenpaketen gehören, ungleichen Schutz für die Pakete in der Vielzahl von Paketen bereitstellt, wobei die Datenpaketteile, die für den zweiten Vorwärtsfehlerkorrekturcode verwendet werden, Fortsetzungen von Datenpaketteilen sind, die für den ersten Vorwärtsfehlerkorrekturcode verwendet werden.

2. Verfahren nach Anspruch 1, wobei die Datenpakete als Echtzeit-Übertragungsprotokoll-Pakete gebildet werden.

3. Verfahren nach Anspruch 1 oder 2, wobei die Vorwärtsfehlerkorrekturcodes XOR- oder Reed-Solomon-Codes sind.

4. Verfahren nach Anspruch 1, 2 oder 3, des Weiteren umfassend: Hinzufügen eines Vorwärtsfehlerkortektur-Headers, der eine Sequenznummer des ersten durch die Vorwärtsfehlerschutzcodes geschützten Paketes und eine Maske enthält, Hinzufügen eines Headers einer ersten ungleichen Schutzschicht zu dem ersten Vorwärtsfehterkorrekturcode und Hinzufügen eines Headers einer zweiten ungleichen Schutzschicht zu dem zweiten Vorwärtsfehlerkorrekturcode, wobei
der Header der ersten ungleichen Schutzschicht die Länge der Daten, die durch den ersten Vorwärtsfehlerkorrekturcode geschützt sind, enthält,
der Header der zweiten ungleichen Schutzschicht die Länge der Daten, die durch den zweiten Vorwärtsfehlerkorrekturcode geschützt sind, und eine Maske enthält und
die Pakete, die durch den ersten und den zweiten Vorwärtsfehlerkorrekturcode geschützt sind, jeweils aus der Sequenznummer und den Masken in dem Vorwärtsfehlerkorrektur-Header und aus dem Header der zweiten ungleichen Schutzschicht bestimmt werden können.

5. Verfahren nach einem der vorhergehenden Ansprüche, wobei der Grad des Schutzes, der einem Datenpaket geboten wird, in Abhängigkeit von der syntaktischen Signifikanz des Paketes eingerichtet wird.

6. Fehlerkorrekturpaketsignal zum Schützen einer Vielzahl von Multimediadatenpaketen, das Signal umfasst einen Echtzeitprotokoll-Header, einen Vorwärtsfehlerkorrektur-Header und eine Vorwärtsfehlerkorrektur-Nutzlast, **dadurch gekennzeichnet, dass** die Vorwärtsfehlerkorrektur-Nutzlast umfasst:
einen Vorwärtsfehlerkorrekturcode-Header, der die Sequenznummer des ersten durch das Vorwärtsfehlerschutzcodepaket geschützten Paketes und eine Maske enthält,
einen Header einer ersten ungleichen Schutzschicht, der eine erste Datenlänge, die durch einen ersten Vorwärtsfehlerkorrekturcode geschützt ist, definiert,
den ersten Vorwärtsfehlerkorrekturcode,
einen Header einer zweiten ungleichen Schutzschicht, der eine zweite die erste Datenlänge erweiternde Datenlänge, die durch einen zweiten Vorwärtsfehlerkorrekturcode geschützt ist, definiert, und
den zweiten Vorwärtsfehlerkorrekturcode, so dass
die Pakete, die durch den ersten und den zweiten Vorwärtsfehlerkorrekturcode geschützt sind, jeweils aus der Sequenznummer und den Masken in dem Vorwärtsfehlerkvrrektur-Header und dem Header der zweiten ungleichen Schutzschicht bestimmt werden können.

7. Vorrichtung zum Senden paketisierter Multimediadaten in einem Funk-Paketnetzwerk, die Vorrichtung umfasst:
Paketisierungseinrichtungen zum Bilden einer Vielzahl von Datenpaketen,
Fehlerschutzeinrichtungen zum Bilden eines Fehlerschutzpaketes für den Fehlerschutz einer Vielzahl von durch die Paketisierungseinrichtungen erzeugten Paketen und
Einrichtungen zum Übertragen von Daten und Fehlerschutzpaketen, die durch die Paketisierungs- und Fehlerschutzeinrichtungen erzeugt wurden,
**dadurch gekennzeichnet, dass** die Fehlerschutzeinrichtung konfiguriert ist, um ein Fehlerschutzpaket zu erzeugen, das ungleichen Schutz für durch die Paketisierungseinrichtung erzeugte Pakete bereitstellt, und Einrichtungen zum Bilden eines ersten Vorvvärtsfehlerkorrekturcodes; der entsprechende Teile der Datenpakete verwendet, und zum Bilden eines zweiten Vorwärtsfehlerkorrekturcodes, der entsprechende Teile von Paketen, die zu Teilmengen von Datenpaketen gehören, umfasst, wobei die Datenpaketteile, die für den zweiten Vorwärtsfehlerkorrekturcode verwendet werden, Fortsetzungen von Datenpaketteilen sind, die für den ersten Vorwärtsfehlerkorrekturcode verwendet werden.

8. Vorrichtung nach Anspruch 7, wobei die Paketisierungseinrichtung konfiguriert ist, um die Datenpakete als Echtzeit-Übertragungsprotokoll-Pakete zu bilden.

9. Vorrichtung nach Anspruch 7 oder 8, wobei die Fehlerschutzeinrichtung konfiguriert ist, um die Fehlerkorrekturcodes als XOR- oder Reed-Solomon-Codes zu erzeugen.

10. Vorrichtung nach Anspruch 9, umfassend Einrichtungen zum Hinzufügen eines Vorwärtsfehlerkorrektur-Headers, der eine Sequenznummer des ersten durch die Vorwärtsfehlerschutzcodes geschützten Paketes und eine Maske enthält, Einrichtungen zum Hinzufügen eines Headers einer ersten ungleichen Schutzschicht zu dem ersten Vorwärtsfehlerkorrekturcode und Einrichtungen zum Hinzufügen eines Headers einer zweiten ungleichen Schutzschicht zu dem zweiten Vorwärtsfehlerkorrekturcode, wobei
der Header der ersten ungleichen Schutzschicht die Länge der Daten, die durch den ersten Vorwärtsfehlerkorrekturcode geschützt sind, enthält,
der Header der zweiten ungleichen Schutzschicht die Länge der Daten, die durch den zweiten Vorwärtsfehlerkorrekturcode geschützt sind, und eine Maske enthält und
die Pakete, die durch den ersten und den zweiten Vorwärtsfehlerkorrekturcode geschützt sind, jeweils aus der Sequenznummer und den Masken in dem Vorwärtsfehlerkorrektur-Header und dem Header der zweiten ungleichen Schutzschicht bestimmt werden können.

11. Vorrichtung nach einem der Ansprüche 7 bis 10, wobei die Fehlerschutzeinrichtung so konfiguriert ist, dass der Grad des Schutzes, der einem Datenpaket geboten wird, in Abhängigkeit von der syntaktischen Signifikanz des Paketes einstellbar ist,

12. Verfahren zum Wiederherstellen wenigstens eines Teils eines verloren gegangenen Paketes, das Verfahren umfasst:
Empfangen einer Vielzahl von Datenpaketen,
Erkennen des Nichtempfangens eines Paketes, **gekennzeichnet durch**
Empfangen eines Fehlerkorrekturpaketsignals nach Anspruch 6,
Wiederherstellen eines ersten Teils des nicht empfangenen Datenpaketes unter Verwendung des ersten Fehlerkorrekturcodes und von Daten aus empfangenen Datenpaketen,
Bestimmen, ob sich der zweite Vorwärtsfehlerkorrekturcode auf ein nicht empfangenes Paket bezieht, aus dem Header der zweiten ungleichen Schutzschicht und
falls sich der zweite Vorwärtsfehlerkorrekturcode auf das nicht empfangene Paket bezieht, Wiederherstellen eines zweiten Teils des Datenpaketes unter Verwendung des zweiten Vorwärtsfehlerkorrekturcodes und von Daten aus empfangenen Datenpaketen.

13. Vorrichtung zum Wiederherstellen wenigstens eines Teils eines verloren gegangenen Paketes, die Vorrichtung umfasst:
Einrichtungen zum Empfangen von Datenpaketen und eines Fehlerkorrekturpaketsignals nach Anspruch 6,
Einrichtungen zum Erkennen des Nichtempfangs eines Datenpaketes,
erste Wiederherstellungseinrichtungen zum Wiederherstellen eines ersten Teils des nicht empfangenen Datenpaketes unter Verwendung des ersten Fehlerkorrekturcodes eines empfangenen Fehlerkorrekturpaketsignals und von Daten aus empfangenen Datenpaketen und
zweite Wiederherstellungseinrichtungen zum Bestimmen, ob sich der zweite Vorwärtsfehlerkorrekturcode eines empfangenen Fehlerkorrekturpaketsignals auf ein nicht empfangenes Paket bezieht, das durch die erste Wiederherstellungseinrichtung teilweise wiederhergestellt ist, aus dem Header der zweiten ungleichen Schutzschicht des empfangenen Fehlkorrekturpaketsignals und
falls sich der zweite Vorwärtsfehlerkorrekturcode auf das nicht empfangene Datenpaket bezieht, Wiederherstellen eines zweiten Teils des nicht empfangenen Datenpaketes unter Verwendung des zweiten Vorwärtsfehlerkorrekturcodes und von Daten aus empfangenen Datenpaketen.

## Revendications

1. Procédé de transmission de données multimédia en paquets dans un réseau sans fil à commutation par paquets, le procédé comprenant les étapes consistant à :
former une pluralité de paquets de données ;
former un paquet de protection d'erreurs afin de protéger ladite pluralité de paquets contre des erreurs ; et
transmettre lesdits paquets de données et lesdits paquets de protection d'erreurs,
**caractérisé en ce que** le paquet de protection d'erreurs procure une protection inégale aux paquets de ladite pluralité de paquets de données en formant un premier code de correction d'erreurs de transmission en utilisant des parties correspondantes desdits paquets de données, et en formant un deuxième code de correction d'erreurs de transmission en utilisant des parties correspondantes de paquets appartenant à un sous-ensemble desdits paquets de données, dans lequel les parties de paquet de données utilisées pour former le deuxième code de correction d'erreurs de transmission, sont des prolongements de parties de paquet de données utilisées pour former le premier code de correction d'erreurs.

2. Procédé selon la revendication 1, dans lequel lesdits paquets de données sont formés sous la forme de paquets d'un Protocole de Transmission en Temps Réel.

3. Procédé selon la revendication 1 ou 2, dans lequel les codes de correction d'erreurs de transmission sont des codes OU EXCLUSIF ou des codes de Reed-Solomon.

4. Procédé selon la revendication 1, 2 ou 3, comprenant les étapes consistant à : ajouter un en-tête de correction d'erreurs de transmission contenant le numéro de séquence du premier paquet protégé par les codes de correction d'erreurs de transmission ainsi qu'un masque, ajouter un premier en-tête de couche de protection inégale au premier code de correction d'erreurs de transmission, et ajouter un deuxième en-tête de couche de protection inégale au deuxième code de correction d'erreurs de transmission, dans lequel :
le premier en-tête de couche de protection inégale contient la longueur des données protégées par le premier code de correction d'erreurs ;
le deuxième en-tête de couche de protection inégale contient la longueur des données protégées par le deuxième code de correction d'erreurs de transmission ainsi qu'un masque ; et
les paquets protégés par le premier et le deuxième codes de correction d'erreurs de transmission peuvent être déterminés à partir dudit numéro de séquence et desdits masques contenus dans l'en-tête de correction d'erreurs de transmission et dans le deuxième en-tête de couche de protection inégale, respectivement.

5. Procédé selon l'une quelconque des revendications précédentes, dans lequel le niveau de protection accordé à un paquet de données est défini en fonction de la signification syntaxique du paquet.

6. Signal de paquet de correction d'erreurs pour protéger une pluralité de paquets de données multimédia, le signal contenant un En-tête de Protocole de Transmission en Temps Réel, un en-tête de correction d'erreurs de transmission et un champ d'information de données utiles de correction d'erreurs de transmission, **caractérisé en ce que** le champ d'information de données utiles de correction d'erreurs de transmission contient :
un en-tête de code de correction d'erreurs de transmission contenant le numéro de séquence du premier paquet protégé par un paquet de code de protection d'erreurs de transmission et un masque ;
un premier en-tête de couche de protection inégale définissant une première longueur des données protégées par un premier code de correction d'erreurs de transmission ;
ledit premier code de correction d'erreurs de transmission ;
un deuxième en-tête de couche de protection inégale définissant une deuxième longueur des données, dans le prolongement de ladite première longueur de données, qui sont protégées par un deuxième code de correction d'erreurs de transmission et un masque ; et
ledit deuxième code de correction d'erreurs de transmission est tel que :
les paquets protégés par le premier et le deuxième codes de correction d'erreurs de transmission peuvent être déterminés à partir dudit numéro de séquence et desdits masques contenus dans l'en-tête de correction d'erreurs de transmission et dans le deuxième en-tête de couche de protection inégale, respectivement.

7. Dispositif de transmission de données multimédia en paquets dans un réseau sans fil à commutation par paquets, le dispositif comprenant :
des moyens de mise en paquets pour former une pluralité de paquets de données ;
des moyens de protection d'erreurs pour former un paquet de protection d'erreurs afin de protéger contre des erreurs une pluralité de paquets formée par les moyens de mise en paquets ; et
des moyens pour transmettre des paquets de données et des paquets de protection d'erreurs formés par les moyens de mise en paquets et les moyens de protection d'erreurs,
**caractérisé en ce que** les moyens de protection d'erreurs sont configurés de façon à former un paquet de protection d'erreurs qui procure une protection inégale aux paquets formés par les moyens de mise en paquets, et comprennent des moyens pour former un premier code de correction d'erreurs de transmission en utilisant des parties correspondantes desdits paquets de données, et pour former un deuxième code de correction d'erreurs de transmission en utilisant des parties correspondantes de paquets appartenant à un sous-ensemble desdits paquets de données, dans lequel les parties de paquets de données utilisées pour former le deuxième code de correction d'erreurs de transmission, sont des prolongements des parties de paquets de données utilisées pour former le premier code de correction d'erreurs.

8. Dispositif selon la revendication 7, dans lequel les moyens de mise en paquets sont configurés de façon à former lesdits paquets de données sous la forme de paquets de Protocole de Transmission en Temps Réel.

9. Dispositif selon la revendication 7 ou 8, dans lequel les moyens de protection d'erreurs sont configurés de façon à former les codes de correction d'erreurs sous la forme de codes OU EXCLUSIF ou de codes de Reed-Solomon.

10. Dispositif selon la revendication 9, comprenant des moyens pour ajouter un en-tête de correction d'erreurs de transmission contenant le numéro de séquence du premier paquet protégé par les codes de correction d'erreurs de transmission ainsi qu'un masque, des moyens pour ajouter un premier en-tête de couche de protection inégale au premier code de correction d'erreurs de transmission, et des moyens pour ajouter un deuxième en-tête de couche de protection inégale au deuxième code de correction d'erreurs de transmission, dans lequel :
le premier en-tête de couche de protection inégale contient la longueur des données protégées par le premier code de correction d'erreurs,
le deuxième en-tête de couche de protection inégale contient la longueur des données protégées par le deuxième code de correction d'erreurs de transmission ainsi qu'un masque ; et
les paquets protégés par le premier et le deuxième codes de correction d'erreurs de transmission peuvent être déterminés à partir dudit numéro de séquence et desdits masques contenus dans l'en-tête de correction d'erreurs de transmission et dans le deuxième en-tête de couche de protection inégale, respectivement.

11. Dispositif selon l'une quelconque des revendications 7 à 10, dans lequel les moyens de protection d'erreurs sont configurés de façon à ce que le niveau de protection accordé à un paquet de données puisse être défini en fonction de la signification syntaxique du paquet.

12. Procédé de régénération d'au moins une partie d'un paquet de données perdu, le procédé comprenant les étapes consistant à :
recevoir une pluralité de paquets de données ;
détecter la non-réception d'un paquet de données ; **caractérisé par** les étapes consistant à :
recevoir un signal de paquet de correction d'erreurs selon la revendication 6 ;
régénérer une première partie du paquet de données non reçu en utilisant ledit premier code de correction d'erreurs et des données provenant desdits paquets de données reçus ;
déterminer si ledit deuxième code de correction d'erreurs de transmission concerne - ou non - ledit paquet de données non reçu à partir dudit deuxième en-tête de couche de protection inégale ; et
si ledit deuxième code de correction d'erreurs de transmission concerne ledit paquet de données non reçu, régénérer une deuxième partie du paquet de données non reçu en utilisant ledit deuxième code de correction d'erreurs de transmission et des données provenant desdits paquets de données reçus.

13. Dispositif de régénération d'au moins une partie d'un paquet de données perdu, le dispositif comprenant :
des moyens pour recevoir des paquets de données et un signal de paquet de correction d'erreurs selon la revendication 6 ;
des moyens pour détecter la non-réception d'un paquet de données ;
des premiers moyens de régénération pour régénérer une première partie d'un paquet de données non reçu en utilisant ledit premier code de correction d'erreurs d'un signal de paquet de correction d'erreurs reçu et des données provenant de paquets de données reçus ; et
des deuxièmes moyens de régénération pour :
déterminer si ledit deuxième code de correction d'erreurs de transmission d'un signal de paquet de correction d'erreurs reçu concerne - ou non - un paquet non reçu, partiellement régénéré par les premiers moyens de régénération, à partir du deuxième en-tête de couche de protection inégale dudit signal de paquet de correction d'erreurs reçu ; et
si ledit deuxième code de correction d'erreurs de transmission concerne effectivement ledit paquet de données non reçu, régénérer une deuxième partie du paquet de données non reçu en utilisant ledit deuxième code de correction d'erreurs de transmission et des données provenant desdits paquets de données reçus.
